(19) Europäisches Patentamt
European Patent Office
Office européen des brevets

(11) **EP 4 593 283 A1**

(12) **EUROPEAN PATENT APPLICATION**

(43) Date of publication:
**30.07.2025 Bulletin 2025/31**

(21) Application number: **25150664.8**

(22) Date of filing: **08.01.2025**

(51) International Patent Classification (IPC):
***H02P 5/74*** *(2006.01)*    ***G01R 31/34*** *(2020.01)*
***H02P 29/02*** *(2016.01)*

(52) Cooperative Patent Classification (CPC):
**H02P 29/02; G01R 31/343; H02P 5/74**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.01.2024 GB 202400995**

(71) Applicant: **Rolls-Royce plc
London N1 9FX (GB)**

(72) Inventors:
• **Vaiyapuri, Viswanathan
Derby, DE24 8BJ (GB)**

• **Nadarajan, Sivakumar
Derby, DE24 8BJ (GB)**
• **Mohamed Halick, Mohamed Sathik
Derby, DE24 8BJ (GB)**
• **Sathyanarayan, Rajaram
Derby, DE24 8BJ (GB)**
• **Gupta, Amit
Derby, DE24 8BJ (GB)**

(74) Representative: **Rolls-Royce plc
P.O. Box 31
IP Department (SinA-48)
Derby Derbyshire DE24 8BJ (GB)**

(54) **ELECTRICAL MACHINE MONITORING**

(57) The disclosure relates to monitoring electrical machines for detecting faults in components. An example embodiment includes a method of monitoring first and second electrical machines ($101_1$, $101_2$) driving respective first and second mechanical loads ($103_1$, $103_2$), the method comprising: measuring first and second sets of currents ($I_{a1}$, $I_{b1}$, $I_{a2}$, $I_{b2}$) through a plurality of stator phases of the respective first and second electrical machines ($101_1$, $101_2$); calculating first and second DC components of a sum of squares of the respective first and second measured sets of currents ($I_{a1}$, $I_{b1}$, $I_{a2}$, $I_{b2}$); calculating a first ratio of the first DC component to the second DC component; and determining a fault in a component ($102_1$, $102_2$) connected to the first or second mechanical loads ($103_1$, $103_2$) if the first ratio is outside of a predetermined range.

*FIG. 1*

EP 4 593 283 A1

## Description

## TECHNICAL FIELD

The disclosure relates to monitoring of electrical machines driving mechanical loads to determine faults in components connected to the mechanical loads.

## BACKGROUND

Urban air mobility (UAM) such as air taxis and electric vertical take-off and landing (eVTOL) vehicles are considered safety and mission critical applications. It is therefore important to ensure reliability and availability of electrical assets in such applications. So-called multi-lane systems may be used in such applications, in which two or more DC supplies provide power to respective electrical machines via power electronics converters. In UAM and eVTOL, identical high power electrical machines are used to drive multiple propulsion systems, each of which correspond to a lane of the multi-lane system. Permanent magnet electrical machines may be used because they offer a high power density, which is particularly advantageous for aerospace application. Any faults in or related to such electrical machines may, however, lead to significant damage to the machine and the associated system.

Bearing and gearbox faults can constitute a significant portion of all electrical machine faults and can be a key reason for downtime of electrical machines. Thus, an accurate detection of any such faults at an early stage is important to identify maintenance needs in advance to reduce any unscheduled down time and consequential loss of revenue.

## SUMMARY

According to a first aspect there is provided a method of monitoring first and second electrical machines driving respective first and second mechanical loads, the method comprising:

measuring first and second sets of currents through a plurality of stator phases of the respective first and second electrical machines;
calculating first and second DC components of a sum of squares of the respective first and second measured sets of currents;
calculating a first ratio of the first DC component to the second DC component; and
determining a fault in a component connected to the first or second mechanical loads if the first ratio is outside of a predetermined range.

The component may comprise a bearing and method may further comprises:

calculating first and second measurements of total harmonic distortion of the respective first and second sets of currents;
calculating a second ratio of the first and second measurements of total harmonic distortion; and
determining a fault in the bearing if the first and second ratios are outside of the predetermined range.

The method may further comprise:

determining a fault in a first bearing connected to the first mechanical load if the first and second ratios are above the predetermined range; and
determining a fault in a second bearing connected to the second mechanical load if the first and second ratios are below the predetermined range.

The predetermined range may be between around 0.95 and 1.05.

The component may comprise a gearbox, the first and second mechanical loads connected to the respective first and second electrical machines via respective first and second gearboxes, the method further comprising:

calculating first and second DC components of instantaneous space phasors (ISPs) of the respective first and second measured sets of currents through the first and second electrical machines;
calculating a second ratio of the first and second DC measurements of ISPs;
determining a fault in the gearbox if the first and second ratios are outside of the predetermined range.

The method may further comprise:

determining a fault in a first gearbox connected to the first mechanical load if the first and second ratios are above a first threshold value; and
determining a fault in a second gearbox connected to the second mechanical load if the first and second ratios are below a second threshold value.

According to a second aspect there is provided a computer program comprising instructions for causing a computer to perform the method according to the first aspect.

According to a third aspect there is provided a multi-lane electric propulsion system for an electric aircraft, the system comprising:

first and second electrical DC power supplies configured to supply first and second DC supply voltages;
first and second multi-phase electrical machines connected to drive respective first and second mechanical loads;

first and second power electronics converters configured to receive the respective first and second DC supply voltages and provide AC electrical power supplies to the first and second multi-phase electrical machines; and
a condition monitoring unit connected to measure first and second sets of currents through a plurality of stator phases of the respective first and second electrical machines,
wherein the condition monitoring unit is configured to:

calculate first and second DC components of a sum of squares of the respective first and second measured sets of currents;
calculate a first ratio of the first DC component to the second DC component; and
determine a fault in a component connected to the first or second mechanical loads if the first ratio is outside of a predetermined range.

The component may comprise a bearing and the condition monitoring unit configured to:

calculate first and second measurements of total harmonic distortion of the respective first and second sets of currents;
calculate a second ratio of the first and second measurements of total harmonic distortion; and
determine a fault in the bearing if the first and second ratios are outside of the predetermined range.

The condition monitoring unit may be configured to:

determine a fault in a first bearing connected to the first mechanical load if the first and second ratios are above the predetermined range; and
determine a fault in a second bearing connected to the second mechanical load if the first and second ratios are below the predetermined range.

The predetermined range may be between around 0.95 and 1.05.
The component may comprise a gearbox, the first and second mechanical loads connected to the respective first and second electrical machines via respective first and second gearboxes, the condition monitoring unit configured to:

calculate first and second DC components of instantaneous space phasors (ISPs) of the respective first and second measured sets of currents through the first and second electrical machines;
calculate a second ratio of the first and second DC measurements of ISPs; and
determine a fault in the gearbox if the first and second ratios are outside of the predetermined range.

The condition monitoring unit may be configured to:

determine a fault in a first gearbox connected to the first mechanical load if the first and second ratios are above a first threshold value; and
determine a fault in a second gearbox connected to the second mechanical load if the first and second ratios are below a second threshold value.

The condition monitoring unit may be configured to provide an output if a fault is determined in the component connected to the first or second mechanical loads.
The first and second electrical machines may be both permanent magnet electrical machines.
The first and second electrical machines may be both three-phase electrical machines.
The first and second electrical machines may be nominally identical.
The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

**BRIEF DESCRIPTION OF THE DRAWINGS**

Embodiments will now be described by way of example only with reference to the accompanying drawings, which are purely schematic and not to scale, and in which:

**Figure 1** is a schematic diagram of an example multi-lane electric propulsion system;
**Figure 2** is a schematic flow chart illustrating an example method of determining the presence of a bearing fault in the system of Figure 1; and
**Figure 3** is a schematic flow chart illustrating an example method of determining the presence of a gearbox fault in the system of Figure 1.

**DETAILED DESCRIPTION**

The reliability of permanent magnet electrical machines can be improved by detecting and diagnosing any faults at an early stage to prevent failures. The availability of such electrical machines can be increased by moving from schedule-based maintenance to condition-based maintenance. Electrical machine health monitoring is a key to improving reliability and availability of such electrical machines by diagnosing any faults at an early stage and, if possible, predicting the time to failure.
Faults in permanent magnet electrical machines can be classified as electrical, mechanical and magnetic faults. In general, mechanical faults such as a bearing fault is a common fault in rotating electrical machines. This is particularly applicable to aerospace applications, in which electrical machines are required to operate at high speed and at high temperatures. This can lead to bearing or gearbox faults becoming common faults in such applications.

Described herein are detection methods for bearing and gearbox components that are based solely on electrical signatures that can be measured across the electrical machines. Compared to vibration-based techniques, electrical-based techniques do not require additional sensors, which makes such techniques potentially a preferred solution for aerospace application due to the reduced weight requirements.

Traditional methods generally use historical data to fix threshold values for the detection of electromechanical faults in electrical machines. Data at different operating conditions over the operating regime is required to allow such thresholds to be fixed. This increases the effort required on analysis and can delay offering or commercialising aerospace electrical machine solutions. The proposed methods described herein allows thresholds to be determined from a comparison between lanes of a multi-lane system instead of using historical data, which can reduce computational effort as well as remove the need for determining and processing representative historical data.

The methods proposed involve simple and accurate algorithms that can be used to detect either a fault in a bearing or gearbox in a multi-lane system. The electrical machines may be in the form of a dual-stator machine, a multiphase machine or multiple-three phase electrical machines.

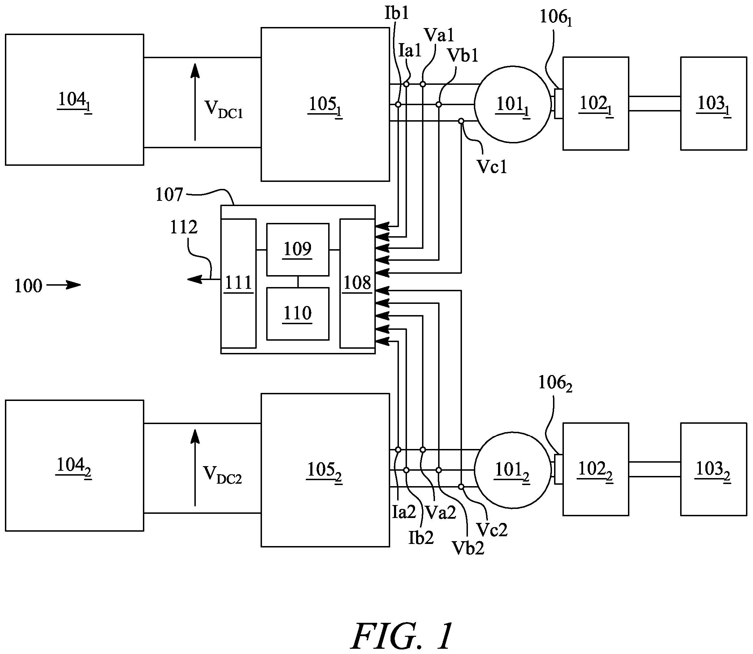

Figure 1 illustrates an example multi-lane electric propulsion system 100 for an electric or hybrid electric aircraft. The system 100 comprises first and second electrical DC power supplies $104_1$, $104_2$. The DC power supplies $104_1$, $104_2$ may each be electrical batteries, or a common battery may provide each of the supplies $104_1$, $104_2$. The DC power supplies $104_1$, $104_2$ provide a DC supply voltage $V_{DC1}$, $V_{DC2}$ to respective power electronics converters $105_1$, $105_2$. The DC supply voltages $V_{DC1}$, $V_{DC2}$ may be of the same magnitude.

Each of the power electronics converters $105_1$, $105_2$ converts the DC supply voltage $V_{DC1}$, $V_{DC2}$ to output AC voltage supplies to drive first and second electrical machines $101_1$, $101_2$. The first and second electrical machines $101_1$, $101_2$ may each be permanent magnet electrical machines and, for the purposes of the method described herein, are nominally identical, i.e. with the same number of phases and windings and with the same power rating.

The first and second electrical machines $101_1$, $101_2$ drive respective first and second mechanical loads $103_1$, $103_2$ via respective first and second gearboxes $102_1$, $102_2$. Each gearbox $103_1$, $103_2$ has one or more bearings $106_1$, $106_2$. The first and second mechanical loads $103_1$, $103_2$ may for example be propulsors for providing thrust and/or lift for the aircraft. In alternative examples, the electrical machines $101_1$, $101_2$ may be connected to the mechanical loads 1031, 1032 without an intervening gearbox $102_1$, $102_2$, but the one or more bearings $106_1$, $106_2$ in each lane will still be present.

Each of the electrical machines $101_1$, $101_2$ may have multiple windings, with the example in Figure 1 illustrating three phases for each electrical machine $101_1$, $101_2$, each of which is driven by a three-phase power electronics converter $105_1$, $105_2$ operating as an inverter, i.e. converting the DC power supply $V_{DC1}$, $V_{DC2}$ to a three phase AC supply to drive each electrical machine $101_1$, $101_2$.

A condition monitoring unit 107 is connected to each lane to acquire voltage and current measurements from sensors in each lane measuring currents provided to, and voltages across, each of the electrical machines $101_1$, $101_2$. The condition monitoring unit 107 is configured to calculate parameters from the current and voltage measurements to assess the health of the bearings and gearboxes (if present) in the system 100.

Figure 1 further illustrates various sensors connected between the power electronics converters 1051, 1052 and the respective electrical machines, the sensors being configured to measure currents Ia1, Ib1 provided to the first electrical machine $101_1$, currents Ia2, Ib2 provided to the second electrical machine $101_2$, voltages Va1, Vb1, Vc1 at each of the phases of the first electrical machine $101_1$ and voltages Va2, Vb2, Vc2 at each of the phases of the second electrical machine $101_2$. Only two currents are shown in each case because the third current can be measured by being inferred from the first two in a three-phase arrangement, although in some examples this additional current may also be directly measured.

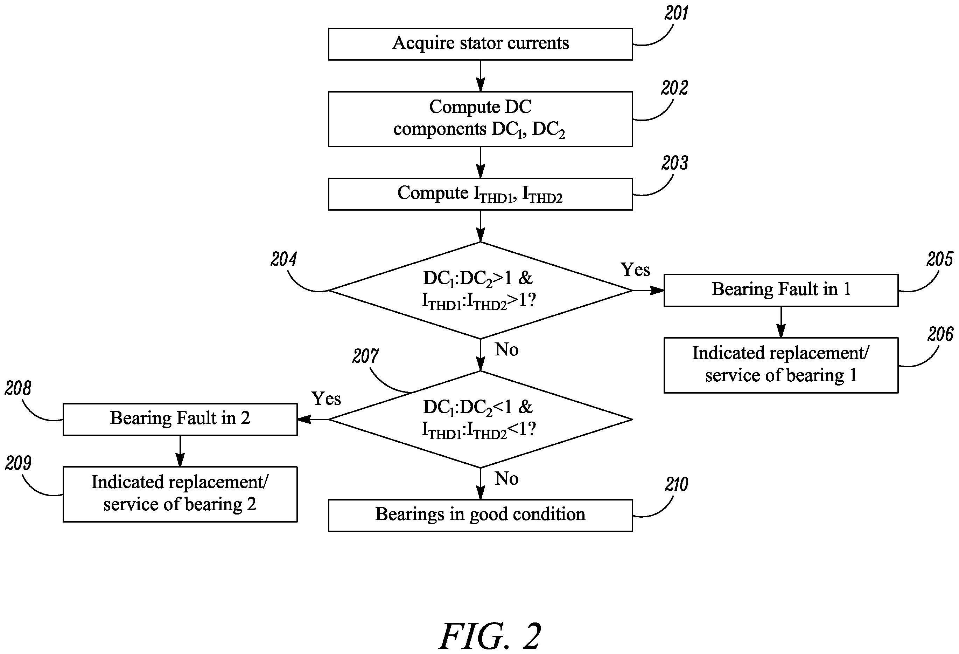

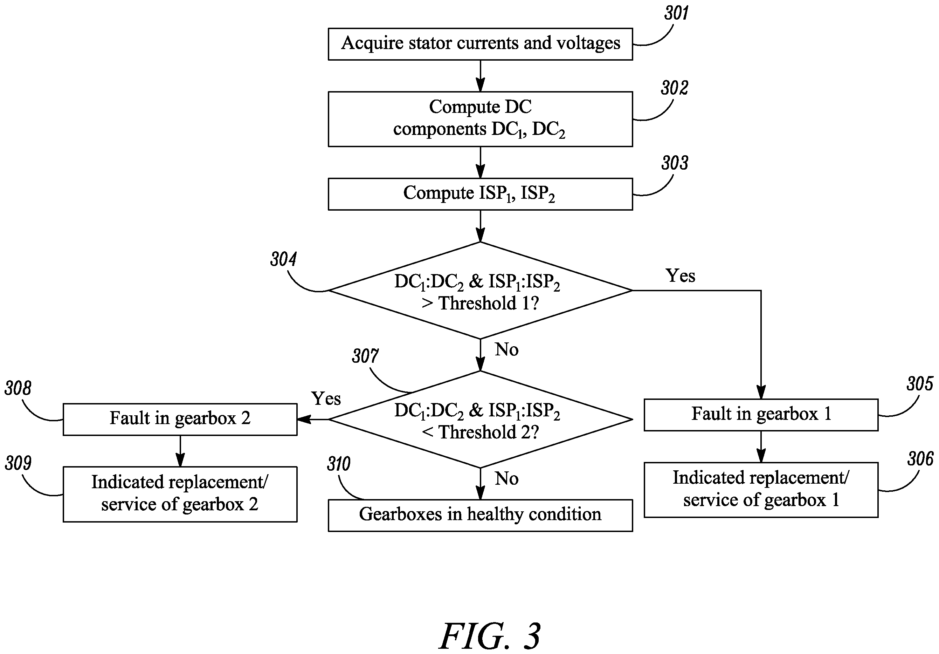

Figures 2 and 3 illustrate algorithms performed by the condition monitoring unit 107 to determine the presence of a fault in either a bearing or a gearbox in the system 100 of Figure 1. The bearing fault detection algorithm in Figure 2 requires only the electrical machine currents to be measured to detect a fault, while the gearbox fault detection algorithm in Figure 3 uses both current and voltage measurements to detect a fault.

In the method illustrated in Figure 2, a first step 201 is to acquire first and second sets of stator currents in the time domain for the respective first and second electrical machines $101_1$, $101_2$. This may be done by directly measuring each of the stator currents Ia1, Ib1, Ic1, Ia2, Ib2, Ic2 provided to each of the electrical machines $101_1$, $101_2$ or may be done by directly measuring all but one of the stator currents in each electrical machine and measuring the remaining current by inference from the others. In the three-phase system 100 of Figure 1 currents Ia1, Ib1 for the first electrical machine $101_1$ and Ia2, Ib2 for the second electrical machine $101_2$ are measured directly and the third stator current Ic1, Ic2 is indirectly measured by being inferred from the other two currents.

In step 202, first and second DC components of a sum of squares of the respective first and second sets of currents are computed from the measured currents. These DC components $DC_1$, $DC_2$ for the respective first and second electrical machines $101_1$, $101_2$ are calculated according to the following equations:

$$DC_1 = mean \sqrt{I_{a1}^2 + I_{b1}^2 + I_{c1}^2}$$

$$DC_2 = mean \sqrt{I_{a2}^2 + I_{b2}^2 + I_{c2}^2}$$

In step 203, first and second measurements of total harmonic distortion (THD) is calculated for the respective first and second sets of currents. The THD of each current is defined as the ratio of the sum of powers of all harmonic components (i.e. all harmonics higher than the driving frequency provided by the electronics power converters $105_1$, $105_2$) to the power of the fundamental frequency. The THD of the currents provided to each of the first and second electrical machines $101_1$, $101_2$, which may be termed $I_{THD1}$, $I_{THD2}$, may therefore be determined to be the sum of THD for the currents in each of the phases.

In step 204, a first ratio between the first DC component $DC_1$ and the second DC component $DC_2$ is determined. Step 204 also comprises determining a second ratio between the first and second measurements of THD of the respective first and second sets of currents. If the first and second ratios are both greater than 1, this indicates a bearing fault connected to the first electrical machine, as indicated in step 205. In step 206 an indication may then be provided by the condition monitoring unit 107 that replacement or service of the first bearing $106_1$ is required. Otherwise, the process moves to step 207. If, at step 207, the first and second ratios are determined at step 204 to be less than 1, this indicates a bearing fault connected to the second electrical machine 1012, as indicated in step 208. In step 209 an indication may then be provided by the condition monitoring unit 107 that replacement or service of the second bearing $106_2$ is required.

If, at step 207, the first and second ratios are determined to be equal to 1, the process proceeds to step 210, and the bearings are determined to be in good condition. The process may then repeat, either continuously or intermittently depending on the application requirements.

Due to operational variations and measurement inaccuracies, the ratios are unlikely to be exactly equal to 1, even when the bearings $106_1$, $106_2$ are in good condition. In an example implementation of the above process therefore, steps 204 and 207 involve comparing the first and second ratios to a predetermined range and determining a fault in one of the bearings $106_1$, $106_2$ if the first and second ratios are outside of this predetermined range. The predetermined range may for example be a small range either side of 1, for example between 0.95 and 1.05, i.e. within +/-5% of 1. The predetermined range may be selected to be different to this depending on the expected or measured variation during normal use.

In the method illustrated in Figure 3, a first step 301 is to acquire first and second sets of stator currents in the time domain for the respective first and second electrical machines $101_1$, $101_2$. In addition to this, voltages Va1, Vb1, Vc1, Va2, Vb2, Vc2 for each phase of the first and second electrical machines $101_1$, $101_2$ are measured.

In step 302, first and second DC components of a sum of squares of the respective first and second sets of currents are computed from the measured currents. These DC components $DC_1$, $DC_2$ for the respective first and second electrical machines $101_1$, $101_2$ are calculated as indicated above in relation to step 202 of the bearing fault detection method.

In step 303, DC components of instantaneous space phasors (ISPs) of the currents through the first and second electrical machines are calculated. The components $I_{11}$, $I_{21}$, $I_{31}$ of the ISPs for a three-phase electrical machine may be calculated according to the following equations:

$$I_{11} = I_a \big( cos(0) + jsin(0) \big)$$

$$I_{21} = abs \left[ I_b \left( cos \left( \frac{2\pi}{3} \right) + jsin \left( \frac{2\pi}{3} \right) \right) \right]$$

$$I_{31} = abs \left[ I_c \left( cos \left( -\frac{2\pi}{3} \right) + jsin \left( -\frac{2\pi}{3} \right) \right) \right]$$

The DC component of each ISP is calculated from the sum of squares of each of the above ISP components, i.e. from Real $(I_{11 +} I_{21} + I_{31})^2 +$ Img $(I_{11 +} I_{21} + I_{31})^2$.

In step 304, a first ratio between the first DC component $DC_1$ and the second DC component $DC_2$ is determined. Step 304 also comprises determining a second ratio between the first and second DC components of ISPs of the respective first and second sets of currents. If the first and second ratios are both greater than a first threshold, this indicates a gearbox fault connected to the first electrical machine, as indicated in step 305. In step 306 an indication may then be provided by the condition monitoring unit 107 that replacement or service of the first gearbox $102_1$ is required. Otherwise, the process moves to step 307. If, at step 307, the first and second ratios are determined to be both less than a second threshold, this indicates a gearbox fault connected to the second electrical machine $101_2$, as indicated in step 308. In step 309 an indication may then be provided by the condition monitoring unit 107 that replacement or service of the second gearbox $102_2$ is required.

If, at step 307, the first and second ratios are determined to be neither above the first threshold nor below the second threshold, the process proceeds to step 310, and the gearboxes $102_1$, $102_2$ are determined to be in good condition. The process may then repeat, either continuously or intermittently depending on the application requirements.

As with the bearing fault monitoring process, the first and second thresholds in steps 304 and 307 may be close to 1, for example slightly above and below 1 respectively. The first and second thresholds in steps 304 and 307 may therefore together define a predetermined range. The predetermined range may be similar to the predetermined range for the bearing fault detection method or may be set differently. The predetermined range may for example be between around 0.95 and 1.05, i.e. with the first threshold at around 1.05 and the second threshold at around 0.95. Other values may apply depending on the application requirements and measurement accuracies.

The above-described methods are implemented on the condition monitoring unit 107. The condition monitoring unit 107 may be a general purpose computer unit comprising an input interface 108 configured to receive the current and voltage signals from the first and second electrical machines 1011, 1012, a processor 109 for processing the signals, calculating the required components and ratios and determining the presence or absence of faults, a memory 110 for storing instructions, sensor data and calculation outputs, and an output interface 111 for providing an output indication 112 to an external unit.

According to an aspect of the invention there is provided a computer program comprising instructions for causing a computer, i.e. the condition monitoring unit, to perform the methods as described herein. The computer program may be a software implementation, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software implementation may be an assembly program.

The computer program may be provided on a non-transitory computer readable medium, which may be a physical computer readable medium, such as a disc or a memory device, or may be embodied as a transient signal. Such a transient signal may be a network download, including an internet download.

**Claims**

1. A method of monitoring first and second electrical

machines ($101_1$, $101_2$) driving respective first and second mechanical loads ($103_1$, $103_2$), the method comprising:

measuring first and second sets of currents ($I_{a1}$, $I_{b1}$, $I_{a2}$, $I_{b2}$) through a plurality of stator phases of the respective first and second electrical machines ($101_1$, $101_2$);
calculating first and second DC components of a sum of squares of the respective first and second measured sets of currents ($I_{a1}$, $I_{b1}$, $I_{a2}$, $I_{b2}$);
calculating a first ratio of the first DC component to the second DC component; and
determining a fault in a component ($102_1$, $102_2$) connected to the first or second mechanical loads ($103_1$, $103_2$) if the first ratio is outside of a predetermined range.

2. The method of claim 1, wherein the component ($102_1$, $102_2$) comprises a bearing ($106_1$, $106_2$) and method further comprises:

calculating first and second measurements of total harmonic distortion of the respective first and second sets of currents ($I_{a1}$, $I_{b1}$, $I_{a2}$, $I_{b2}$);
calculating a second ratio of the first and second measurements of total harmonic distortion; and
determining a fault in the bearing ($106_1$, $106_2$) if the first and second ratios are outside of the predetermined range.

3. The method of claim 2, further comprising:

determining a fault in a first bearing ($106_1$) connected to the first mechanical load ($102_1$, $103_1$) if the first and second ratios are above the predetermined range; and
determining a fault in a second bearing ($106_2$) connected to the second mechanical load ($102_2$, $103_2$) if the first and second ratios are below the predetermined range.

4. The method of any preceding claim, wherein the predetermined range is between around 0.95 and 1.05.

5. The method of any preceding claim, wherein the component comprises a gearbox ($102_1$, $102_2$), the first and second mechanical loads ($103_1$, $103_2$) are connected to the respective first and second electrical machines via respective first and second gearboxes ($102_1$, $102_2$), the method further comprising:

calculating first and second DC components of instantaneous space phasors, ISPs, of the respective first and second measured sets of currents ($I_{a1}$, $I_{b1}$, $I_{a2}$, $I_{b2}$) through the first and second electrical machines ($101_1$, $101_2$);

calculating a second ratio of the first and second DC measurements of ISPs;

determining a fault in the gearbox ($102_1$, $102_2$) if the first and second ratios are outside of the predetermined range.

6. The method of claim 5, further comprising:

determining a fault in a first gearbox ($102_1$) connected to the first mechanical load ($103_1$) if the first and second ratios are above a first threshold value; and

determining a fault in a second gearbox ($102_2$) connected to the second mechanical load ($103_2$) if the first and second ratios are below a second threshold value.

7. A multi-lane electric propulsion system (100) for an electric aircraft, the system (100) comprising:

first and second electrical DC power supplies ($104_1$, $104_2$) configured to supply first and second DC supply voltages ($V_{DC1}$, $V_{DC2}$);

first and second multi-phase electrical machines ($101_1$, $101_2$) connected to drive respective first and second mechanical loads ($103_1$, $103_2$);

first and second power electronics converters ($105_1$, $105_2$) configured to receive the respective first and second DC supply voltages ($V_{DC1}$, $V_{DC2}$) and provide AC electrical power supplies to the first and second multi-phase electrical machines ($101_1$, $101_2$); and

a condition monitoring unit (107) connected to measure first and second sets of currents ($I_{a1}$, $I_{b1}$, $I_{a2}$, $I_{b2}$) through a plurality of stator phases of the respective first and second electrical machines ($101_1$, $101_2$),

wherein the condition monitoring unit (107) is configured to:

calculate first and second DC components of a sum of squares of the respective first and second measured sets of currents ($I_{a1}$, $I_{b1}$, $I_{a2}$, $I_{b2}$);

calculate a first ratio of the first DC component to the second DC component; and

determine a fault in a component ($102_1$, $102_2$) connected to the first or second mechanical loads ($103_1$, $103_2$) if the first ratio is outside of a predetermined range.

8. The system (100) of claim 7, wherein the component ($102_1$, $102_2$) comprises a bearing ($106_1$, $106_2$) and the condition monitoring unit (107) is configured to:

calculate first and second measurements of total harmonic distortion of the respective first and second sets of currents ($I_{a1}$, $I_{b1}$, $I_{a2}$, $I_{b2}$);

calculate a second ratio of the first and second measurements of total harmonic distortion; and

determine a fault in the bearing ($106_1$, $106_2$) if the first and second ratios are outside of the predetermined range.

9. The system (100) of claim 8, wherein the condition monitoring unit (107) is configured to:

determine a fault in a first bearing ($106_1$) connected to the first mechanical load ($102_1$, $103_1$) if the first and second ratios are above the predetermined range; and

determine a fault in a second bearing ($106_2$) connected to the second mechanical load ($102_2$, $103_2$) if the first and second ratios are below the predetermined range.

10. The system (100) of any one of claims 7 to 9, wherein the predetermined range is between around 0.95 and 1.05.

11. The system (100) of any one of claims 7 to 10, wherein the component comprises a gearbox ($102_1$, $102_2$), the first and second mechanical loads ($103_1$, $103_2$) are connected to the respective first and second electrical machines via respective first and second gearboxes ($102_1$, $102_2$), the condition monitoring unit configured to:

calculate first and second DC components of instantaneous space phasors, ISPs, of the respective first and second measured sets of currents ($I_{a1}$, $I_{b1}$, $I_{a2}$, $I_{b2}$) through the first and second electrical machines ($101_1$, $101_2$);

calculate a second ratio of the first and second DC measurements of ISPs; and

determine a fault in the gearbox ($102_1$, $102_2$) if the first and second ratios are outside of the predetermined range.

12. The system (100) of any one of claims 7 to 11, wherein the condition monitoring unit (107) is configured to provide an output (112) if a fault is determined in the component ($102_1$, $102_2$) connected to the first or second mechanical loads ($103_1$, $103_2$).

13. The system (100) of any one of claims 7 to 12, wherein the first and second electrical machines ($101_1$, $101_2$) are both permanent magnet electrical machines.

14. The system (100) of any one of claims 7 to 13, wherein the first and second electrical machines ($101_1$, $101_2$) are both three-phase electrical machines.

15. The system (100) of any one of claims 7 to 14, wherein the first and second electrical machines ($101_1$, $101_2$) are nominally identical.

*FIG. 1*

201 Acquire stator currents

202 Compute DC components $DC_1$, $DC_2$

203 Compute $I_{THD1}$, $I_{THD2}$

204 $DC_1{:}DC_2>1$ & $I_{THD1}{:}I_{THD2}>1$?

Yes

205 Bearing Fault in 1

206 Indicated replacement/ service of bearing 1

No

207 $DC_1{:}DC_2<1$ & $I_{THD1}{:}I_{THD2}<1$?

Yes

208 Bearing Fault in 2

209 Indicated replacement/ service of bearing 2

No

210 Bearings in good condition

FIG. 2

$$\text{Acquire stator currents and voltages} \quad 301$$

$$\downarrow$$

Compute DC components $DC_1$, $DC_2$ — 302

$$\downarrow$$

Compute $ISP_1$, $ISP_2$ — 303

304 — $DC_1:DC_2$ & $ISP_1:ISP_2$ > Threshold 1?

Yes → Fault in gearbox 1 — 305 → Indicated replacement/ service of gearbox 1 — 306

No ↓

307 — $DC_1:DC_2$ & $ISP_1:ISP_2$ < Threshold 2?

Yes → Fault in gearbox 2 — 308 → Indicated replacement/ service of gearbox 2 — 309

No ↓

Gearboxes in healthy condition — 310

*FIG. 3*

EP 4 593 283 A1

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2024/004442 A1 (DENSO CORP [JP]) 4 January 2024 (2024-01-04) | 1,4,7, 10,13-15 | INV. H02P5/74 |
| A | * the whole document * | 2,3,5,6, 8,9,11, 12 | G01R31/34 H02P29/02 |
| A | US 2023/353076 A1 (HIRAKATA MASAKI [JP]) 2 November 2023 (2023-11-02) * the whole document * | 1-15 | |
| A | US 2016/216334 A1 (ATHIKESSAVAN SUBASH C [SG] ET AL) 28 July 2016 (2016-07-28) * the whole document * | 1-15 | |
| A | US 11 050 378 B2 (PARKER HANNIFIN CORP [US]) 29 June 2021 (2021-06-29) * the whole document * | 1-15 | |

| | TECHNICAL FIELDS SEARCHED (IPC) |
|---|---|
| | H02P G01R |

The present search report has been drawn up for all claims

| Place of search | Date of completion of the search | Examiner |
|---|---|---|
| Munich | 15 May 2025 | Wimböck, Thomas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

...................................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 15 0664

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2025

| Patent document cited in search report | Publication date | Patent family member(s) | | Publication date |
|---|---|---|---|---|
| WO 2024004442 A1 | 04-01-2024 | EP | 4546636 A1 | 30-04-2025 |
| | | US | 2025066017 A1 | 27-02-2025 |
| | | WO | 2024004442 A1 | 04-01-2024 |
| US 2023353076 A1 | 02-11-2023 | CN | 116896304 A | 17-10-2023 |
| | | JP | 7156565 B1 | 19-10-2022 |
| | | JP | 2023147450 A | 13-10-2023 |
| | | US | 2023353076 A1 | 02-11-2023 |
| US 2016216334 A1 | 28-07-2016 | EP | 3054307 A1 | 10-08-2016 |
| | | GB | 2534406 A | 27-07-2016 |
| | | US | 2016216334 A1 | 28-07-2016 |
| US 11050378 B2 | 29-06-2021 | NONE | | |

EPO FORM P0459

For more details about this annex : see Official Journal of the European Patent Office, No. 12/82